Europäisches Patentamt

European Patent Office

Office européen des brevets

(11) Publication number: **0 220 700**
A2

# EUROPEAN PATENT APPLICATION

(21) Application number: 86114837.7

(22) Date of filing: 24.10.86

(51) Int. Cl.⁴: **H 03 H 7/46**

(30) Priority: 29.10.85 IT 2264685

(43) Date of publication of application: 06.05.87
Bulletin 87/19

(84) Designated Contracting States: **AT BE CH DE ES FR GB
GR LI LU NL SE**

(71) Applicant: **Motta, Tino Giuseppe, Via A. Grandi 143/A,
I-20043 Arcore (Milano) (IT)**
Applicant: **Motta, Natale, Via A. Grandi 143/A,
I-20043 Arcore (Milano) (IT)**
Applicant: **Zappa, Emilia, Via A. Grandi 143/A,
I-20043 Arcore (Milano) (IT)**

(72) Inventor: **Motta, Tino Giuseppe, Via A. Grandi 143/A,
I-20043 Arcore (Milano) (IT)**
Inventor: **Motta, Natale, Via A. Grandi 143/A,
I-20043 Arcore (Milano) (IT)**
Inventor: **Zappa, Emilia, Via A. Grandi 143/A,
I-20043 Arcore (Milano) (IT)**

(74) Representative: **Lecce, Giovanni, Dott. Giovanni Lecce
& C. S.r.l. Via G. Negri 10, I-20123 Milano (IT)**

(54) Insertion system for control and/or power supply voltages in a coaxial cable for radio-frequency.

(57) An insertion system of power supply and/or control voltages, deriving from a power supply and/or control box, in a coaxial cable for radio-frequency, comprising an injector or R.F. filter (10), equipped with plugs (2) and (3) or clamps, which is applied in series at any point on the coaxial cable (9) included between a receiver (13) and an amplifier, selectors, converter, and/or aerial directional devices and the like.

The injector (10) is coupled to a control and/or power supply box (1) by means of a simple bipolar conductor (8) through which transit only the control and/or power supply voltages, either in the form of continuous signals, or in the form of possible continuous or alternating power supply voltages, coupled or not to pulsed control voltages or with pulse trains overlapping the power supply voltages, coded or not, which may be used for other purposes.

"INSERTION SYSTEM FOR CONTROL AND/OR POWER SUPPLY VOLTAGES

IN A COAXIAL CABLE FOR RADIO-FREQUENCY".


The invention relates to an insertion system for power supply and/or control voltages , deriving from a power supply and/or control box or from a power pack,    in a coaxial cable for radio-frequency.

As is known, in the present radio/television reception installations, connection of the control and/or power supply box to the remainder of the system is usually achieved by means of a twin-wire or bipolar conductor, suitable for delivering the power supply of the electric network, and two coaxial cables, of which : one directed towards the amplification, switching, conversion or rotation equipment placed in the vicinity of the aerials and/or various radio-television systems ; and the other directed to the receiver.

These installations, though valid from a functional point of view, do, however, manifest certain particular defects.

The first defect may be attributed to the fact that the installation and placing of the coaxial cables in the above-mentioned installations always proves to be tiresome and difficult  due to their non-flexibility deriving from the magnitude of their diameter, in the range of roughly 7 MM, required to avoid excessive attenuation of the signals which pass through them, especially over long runs.

Another drawback is due to the fact that said coaxial cables, arranged haphazardly in the installations placed inside private abodes, necessarily remain in sight, thus creating a decidely false note in the surrounding environment.

In the same way, positioning of the power supply and/or control boxes, especially in the immediate vicinity of radio/ television receivers proves to be particularly inconvenient, difficult and anti-aesthetic.

The aim of the present invention is to eliminate the drawbacks mentioned beforehand and, at the same time, to avoid considerable signal losses, or external interferences which affect the signals transiting in the coaxial cable.

The invention, such as it is characterized in the claims, solves the problem by means of an insertion system of power supply and/or control voltages deriving from a power supply and/or control box or from a power pack, in a coaxial cable for radio-frequency.

By means of the use of a system of this type, the following results are obtained : the injector or R.F. filter is realized separately from the power supply and switching box and is connected to it through a bipolar conductor ; since the injector is detached from the control or power supply box, the two traditional coaxial cables, for transmission of the radio-frequency signals, are no longer connected to the box; the injector or R.F. filter may be directly inserted in the R.F. input connectors of the receivers, in the aerial plugs or connectors of the equipment or at any point in series on the coaxial cable between receivers and amplifier, switching, convertor or rotation devices and the like, whereas its power is obtained either directly from the power supply and/or control box or from a power pack by means of an ordinary electrical bipolar conductor.

The advantages obtained from using the present invention, consist mainly in the fact that it is possible to insert onto a coaxial cable for radio-frequency the power supply and/or control voltage(s) deriving from an ordinary power supply and/or control box, by means of a simple injector and a common bipolar conductor, regardless of the fact that these signals are continuous, with varying, alternating voltage and/or polarity, with pulses or impulse trains ; by using the injector one avoids, moreover, employment of over-long coaxial cables for radio-frequency for the connection of the control and/or power supply boxes to the installations, without affecting or attenuating to any noticeable degree the R.F. signals transiting therein, and the injector may be equipped with connectors for the coaxial cable with screw clamps or coaxial plugs which may be fitted to the various standard connectors on the market.

Another advantage consists in the fact that the separation of the above mentioned components permits easy installation and positioning of the power supply and/or control boxes of any device which must be powered or controlled by means of a coaxial cable, such as, for example : R.F. amplifiers, convertors, switching systems; rotors for aerials and the like.

4.

0220700

These power supply and/or control boxes may be placed either near or far from the receiving equipment or from the plugs or connectors of the instruments' aerials or also from the line in coaxial cable.

To understand the present invention better, it will be explained in greater detail in the following description with reference to the appended drawings, which represent some illustrative but not restricted embodiments of the present invention, in which :

Figures 1 and 2 show functional diagrams of receiving apparatus using the system described in the present invention ;

Figures 3 and 4 show a schematic view of two construction models of two types of injectors or R.F. filters and,

figure 5 represents a preferred but not restrictive embodiment of an electric diagram corresponding to the injectors or R.F. filters illustrated in figures 3 and 4.

The figures show the means to accomplish an insertion system of power supply and/or control voltages, deriving from a power supply and/or control box or from a power pack, in a coaxial cable for radio-frequency, mainly consisting of (1) a power supply and control box which supplies the power supply and control voltages to the injector, or R. F. filter (10) through its output (1b).

The control box or power pack (1) is connected to the electric network through its input (1A) and the current tap (11).

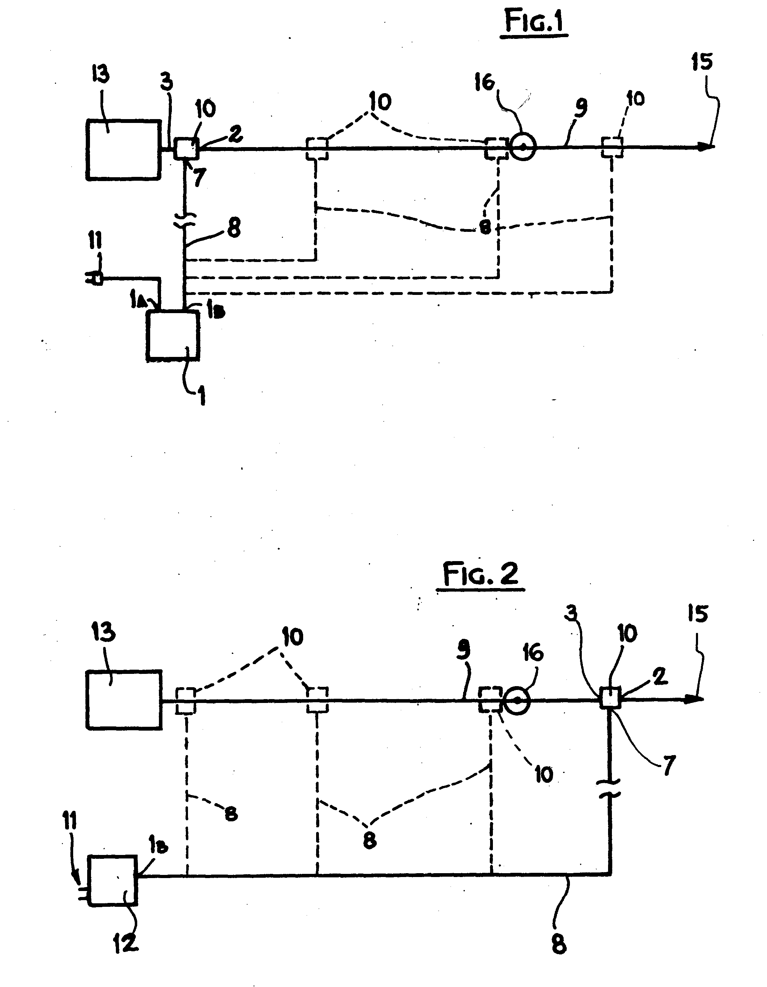

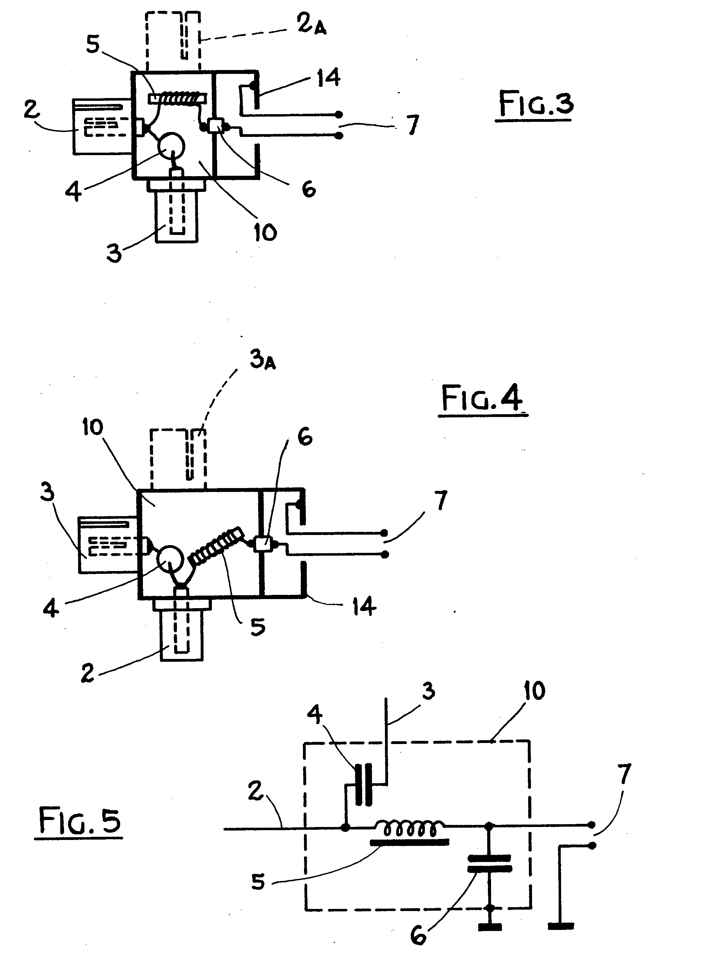

As an alternative, the power pack (1) and the tap (11) may be incorporated in one single unit (12), as may be seen in Figure 2. In any case, the power pack (1) may be of any known type. The radio-frequency filter (10), which from now on will be called preferably "injector", receives on its input (7) all the power supply and control voltages sent by the power pack (1) by means of a normal electric bipolar conductor (8). Through the connector (2) and the coaxial cable (9), the injector (10) transmits said voltages to the other parts of the system, preventing the passage of said voltages onto the connector (3) directed towards the receiving apparatus (13). At the same time, the injector (10) permits passage of the R.F. signals between the connectors 2 and 3, thus impeding the transit from the input 7.

Figure 3 shows an injector (10) according to its preferred but not restrictive construction version, which may be directly inserted into the coaxial input connector of a radio/television receiver 13. It is contained in an outer casing (14) made of conductive material, screening the radio-frequency in such a way as to avoid external R.F. interferences. The presence of said casing (14), though preferable, is, nonetheless, not indispensable for the correct functioning of the injector (10). By the numeral 2 is indicated the coaxial connector used for connecting with the coaxial cable (9) deriving from the amplifying circuits, attenuators, R.F. convertors or from the mobile directional devices applied to the aerials, not indicated in figures 1 and 2, but present beyond the arrow 15. The coaxial connection 3 is on the other hand used at the input of any type of receiving apparatus 13. The capacitor 4 presents a very low impedance for R.F. and an infinite impedance (open circuit) for direct current and/or low frequency. The numeral 5 indicates an impedance and N°6 a feedthrough capacitor, which are able to block the transit of R.F. from the connection 2 to the input 7, and vice-versa, without interfering with or noticeably attenuating the transit of the R.F. signals, through the connectors 2 and 3. The input 7 for the control and power supply voltages is connected to the power pack 1 by means of a simple bipolar conductor 8 of reduced dimensions, (for example 2 x 0.5 mmg) one end of which is connected to the container 14, or ground of the injector 10.

Figure 4 shows an injector 10, according to an alternative but not restrictive construction version, which may be applied directly to the plugs or connections 16 present in dwellings,or in the vicinity of each apparatus. This solution differs from the former merely by the fact that the coaxial connectors 2 and 3 have the male and female taps inverted. The numerals 2A and 3A show how the connections 2 and 3 may possibly be arranged in an axial direction.

At all events, the injector 10 may be positioned at any point between the receiving apparatus 13 and the amplifier circuits or devices, attenuators, R.F. converters and/or mobile directional devices which may be applied to the aerials, present beyond the arrow marked by N° 15 in figures 1 and 2.

In the same way, the injector 10 has the same characteristics, even if, instead of the coaxial connectors 2 and 3 use is made of normal screw clamps. Figure 5 shows the electrical diagram corresponding to the injector 10. Judging from the former description it is evident that the system makes application of the devices to all types of installation far easier, swifter, more economical and functional. Moreover, it is important to point out that a connector may be attached,respectively, on the input 7 and/or on the output 1B (to which is connected the common electrical bipolar conductor 8), to the injector 10 and/or to the power supply and control box, or power pack 1 or 12, in such a way as to obtain the easy and rapid interchangeability of said injector 10 and/or the type of power pack 1 or 12.

Moreover, this system has the essential property of being able to allow positioning of the box comprising the power pack 1, to be used for feeding and/or controlling any type of device which must be fed or controlled through a coaxial cable such as, for example, R.F. amplifiers, convertors, switching systems, rotors for aerials and the like, near to or far from the receiver apparatus 13 or from the plug or aerial connector 16 or from the line in coaxial cable for R.F. 9, merely by shortening or lengthening the common bipolar conductor 8 which connects the injector 10 to the box 1 or 12.

0220700

## CLAIMS

1. Insertion system of power supply and/or control voltages, deriving from a power supply and/or control box, or from a power pack, in a coaxial cable for radio-frequency, which comprises an injector, or R.F. filter (10), the input of which (7) is connected to a control and/or power supply box (1) through a common bipolar conductor (8) and the connectors (2) and (3) are attached in series to the coaxial cable (9), deriving from the receiving apparatus.

2. System according to claim 1, characterized by the fact that through the bipolar conductor (8) transit only the control and/or power supply voltages, either in the form of continuous signals with varying voltage and/or polarity, or under the form of possible continuous or alternating power supply voltages coupled or not with pulsed control voltages or with pulse trains overlapping the power supply voltages, coded or not, which may be used for other purposes.

3. System according to claim 1, characterized by the fact that the pairing of injector (10)/control box or power pack (1) comprises an insertion system of control and/or power supply voltages for control apparatus for aerial rotors or for power packs and/or control boxes for aerial equipment.

0220700

4. System according to any of the previous claims, characterized by the fact that the injector (10) is directly fed by a power supply and/or control box , or power pack (1), by means of a common electric bipolar conductor, which is flexible, adaptable and of reduced dimensions.

5. System according to any of the former claims, characterized by the fact that the injector (10) is equipped with connectors for the coaxial cable (9), with screw clamps or with male or female plugs (2), (3) and (3A) adaptable to standard connectors.

6. System according to any of the previous claims, characterized by the fact that the injector (10) or R.F. filter may be directly inserted : on the R.F. input connectors of the receivers (13) ; in the plugs or aerial connectors (16) of the instruments or at any intermediate point ; in series with the coaxial cable (9), between said receivers (13) and the amplifier, switching, convertor devices and/or aerial rotation devices or other apparatus.

7. System according to any of the former claims, characterized by the fact that the injector (10) is encased or built in a casing made of conductive material to serve as a screen of radio-frequencies, or not.

8. System according to any of the previous claims, characterized by the fact that the injector (10) comprises an R.F. filter of known type.

9. System according to any of the former claims, characterized by the fact that the input (7) of the injector (10) and/or output (1B) of the power supply and control box or power pack (1) or (12) are equipped with connectors in which are plugged the ends of a normal electrical bipolar conductor (8).

0220700

1|2

Fig.1

Fig. 2

0220700

2/2

Fig.3

Fig.4

Fig.5